(19) **Europäisches Patentamt**

**European Patent Office**

**Office européen des brevets**

(11) **EP 0 969 521 A1**

(12) **EUROPÄISCHE PATENTANMELDUNG**

(43) Veröffentlichungstag:
05.01.2000 Patentblatt 2000/01

(51) Int. Cl.$^7$: **H01L 31/048**, B32B 31/00

(21) Anmeldenummer: 98112319.3

(22) Anmeldetag: 03.07.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder:
• **ISOVOLTA**
**Österreichische Isolierstoffwerke Aktiengesellschaft**
**2355 Wiener Neudorf (AT)**
• **FRAUNHOFER-GESELLSCHAFT ZUR FÖRDERUNG DER ANGEWANDTEN FORSCHUNG E.V.**
**80636 München (DE)**

(72) Erfinder:
• **Plessing, Albert, K., Dipl. Ing. Dr**
**8302 Brunn 28 (AT)**
• **Langowski, Horst-Christian, Dr.**
**85406 Zolling (DE)**
• **Moosheimer, Ulrich, Dr.**
**85411 Hohenkammer (DE)**

(74) Vertreter: **Dungler, Karin**
**Isovolta**
**Österreich. Isolierstoffwerke AG**
**Industriezentrum NÖ-Süd**
**Isovoltastrasse 3**
**2355 Wiener Neudorf (AT)**

(54) **Fotovoltaischer Modul sowie ein Verfahren zu dessen Herstellung**

(57) Es wird ein fotovoltaischer Modul 1 in Form eines Laminates angegeben, welches als Kernschicht ein Solarzellensystem 2 sowie beidseitig an dieses angebrachte Einkapselungsmaterialien 3,3' aufweist. Erfindungsgemäß besteht zumindestens eine Einkapselungsmaterialschicht 3' aus einer Siegelschicht 4' und einer Barriereschicht 6, welche aus einer Kunststoffolie oder einem Kunststoff-Folienverbund ausgebildet ist und auf welche(r) eine aus der Dampfphase abgeschiedene, anorganische Oxidschicht 7 vorliegt.

Fig. 1

**Beschreibung**

Die Erfindung betrifft einen fotovoltaischen Modul in Form eines Laminates, welches ein Solarzellensystem sowie dafür vorgesehene Einkapselungsmaterialien aufweist. Es wird ferner erfindungsgemäß ein Verfahren zu dessen Herstellung geoffenbart.

Stand der Technik

Fotovoltaische Module dienen zur elektrischen Energieerzeugung aus Sonnenlicht. Die Energieerzeugung erfolgt dabei durch das Solarzellensystem, welches vorzugsweise durch Siliziumzellen ausgebildet ist. Diese sind jedoch mechanisch nur gering belastbar, sodaß sie beidseitig mit Einkapselungsmaterialien umhüllt werden müssen. Als Einkapselungsmaterialien dienen beispielsweise ein oder mehrere Schichten aus Glas und/oder Kunststoffolien und/oder Kunststoffolienverbunden.

Kunststoffolienverbunde, bestehend im wesentlichen aus Polyvinylfluorid (PVF) und Polyethylenterephthalat (PET), werden von der Anmelderin unter der Bezeichnung ICOSOLAR produziert und in einem gemäß der WO-A1-94/29106 geoffenbarten Vakuumlaminierverfahren zur Herstellung von fotovoltaischen Modulen eingesetzt. Das Solarzellensystem ist in diesen Modulen nicht nur gegen mechanische Beschädigungen sondern auch gegen Witterungseinflüsse, insbesondere gegen Wasserdampf geschützt. Als Barriereschicht gegenüber Wasserdampf ist im ICOSOLAR-Folienverbund eine Zwischenschicht aus Aluminium vorgesehen. Diese hat jedoch den Nachteil, daß sie in Verbindung mit dem Solarzellensystem elektrisch leitend ist, sodaß unerwünschte Fremdströme im fotovoltaischen Modul entstehen.

Darstellung der Erfindung

Aufgabe der Erfindung ist es daher, einen fotovoltaischen Modul der eingangs genannten Art anzugeben, welcher diesen Nachteil nicht aufweist, jedoch gegenüber Wasserdampf weitestgehend undurchlässig ist.

Zur Lösung dieser Aufgabe wird erfindungsgemäß ein fotovoltaischer Modul vorgeschlagen, welcher dadurch gekennzeichnet ist, daß zumindestens eine Einkapselungsmaterialschicht aus einer Siegel- und einer Barriereschicht besteht und daß die Barriereschicht aus einer Kunststoffolie oder einem Kunststoffolienverbund ausgebildet ist, welche(r) an der dem Solarzellensystem zugewandten Seite mit einer aus der Dampfphase abgeschiedenen, anorganischen Oxidschicht versehen ist.

Ein weiterer Vorteil des erfindungsgemäßen fotovoltaischen Moduls besteht darin, daß die anorganische Oxidschicht aus den Elementen Aluminium oder Silicium besteht und in einer Dicke von 30 bis 200 nm vorliegt. Die organische Oxidschicht weist ferner den Vorteil auf, daß sie im sichtbaren Lichtwellenbereich und im nahen UV-Wellenlängenbereich für Lichtstrahlen durchlässig ist, während sie im UV-Wellenlängenbereich bei kürzeren Wellenlängen diese absorbiert.

Das erfindungsgemäße fotovoltaische Modul weist ferner den Vorteil auf, daß die Siegelschicht zwischen dem Solarzellensystem und der Barriereschicht angeordnet ist und vorzugsweise aus Ethylenvinylacetat (EVA) besteht.

Erfindungsgemäß besteht ferner die Kunststoffolie, auf welcher die anorganische Oxidschicht abgeschieden ist, aus Polyethylenterephthalat (PET) oder Ethylentetrafluoroethylencopolymer (ETFE).

Weitere Vorteile des erfindungsgemäßen fotovoltaischen Moduls bestehen darin, daß die anorganische Oxidschicht dem Solarzellensystem zugewandt ist und mit der angrenzenden Siegelschicht direkt oder über eine Primerschicht in Kontakt steht.

Ferner ist die anorganische Oxidschicht erfindungsgemäß beidseitig von Kunststoffolien oder -verbunden umgeben, wobei zumindestens eine Kunststoffolie oder ein Kunststoffolienverbund die Funktion der Barriereschicht übernimmt. Dabei steht die anorganische Oxidschicht vorteilhafterweise über zumindestens eine Kleberschicht mit dem Kunststoffolien oder -verbunden in Kontakt.

Erfindungsgemäß besteht die anorganische Oxidschicht aus $SiO_x$, wobei das atomare Verhältnis von Silizium zu Sauerstoff x in einem Bereich von 1,3 - 1,7 liegt.

Die Erfindung betrifft ebenso ein Verfahren zur Herstellung eines fotovoltaischen Moduls, wobei vorteilhafterweise a) eine Kunststoffolie oder ein Kunststoffolienverbund mit einer aus der Dampfphase abgeschiedenen, anorganischen Oxidschicht versehen wird, b) ein Modulstapel, welcher aus dem Solarzellensystem sowie den Einkapselungsmaterialien verschlichtet wird, daß die Siegelschichten das Solarzellensystem beidseitig umhüllen, c) dieser Modulstapel in eine Beladestation einer Verfahrensvorrichtung eingebracht wird, in welcher er auf eine Temperatur unterhalb der Erweichungstemperatur der Siegelschichten gehalten wird, d) der Modulstapel in einem Vakuumlaminator in dieser Vorrichtung transportiert wird, welcher evakuiert wird, und in welchem der Modulstapel auf die Erweichungstemperatur der Siegelschichten erwärmt wird und e) nach dem Belüften des Vakuumlaminators ohne Rückkühlung der aus dem Modulstapel gebildete Verbund in einen Härteofen transportiert wird, in welchem die Siegelschichten ausgehärtet werden, sodaß ein Laminat in Form eines fotovoltaischen Moduls gebildet wird, welches nach Rückkühlung dem kontinuierlichen Verfahrensablauf entnommen werden kann.

Kurze Beschreibung der Zeichnungen

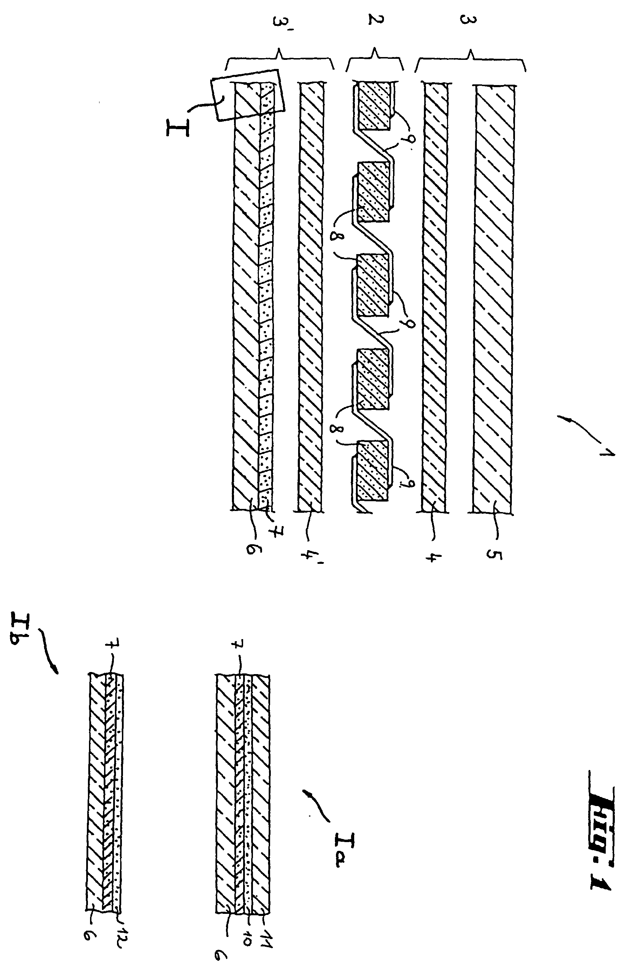

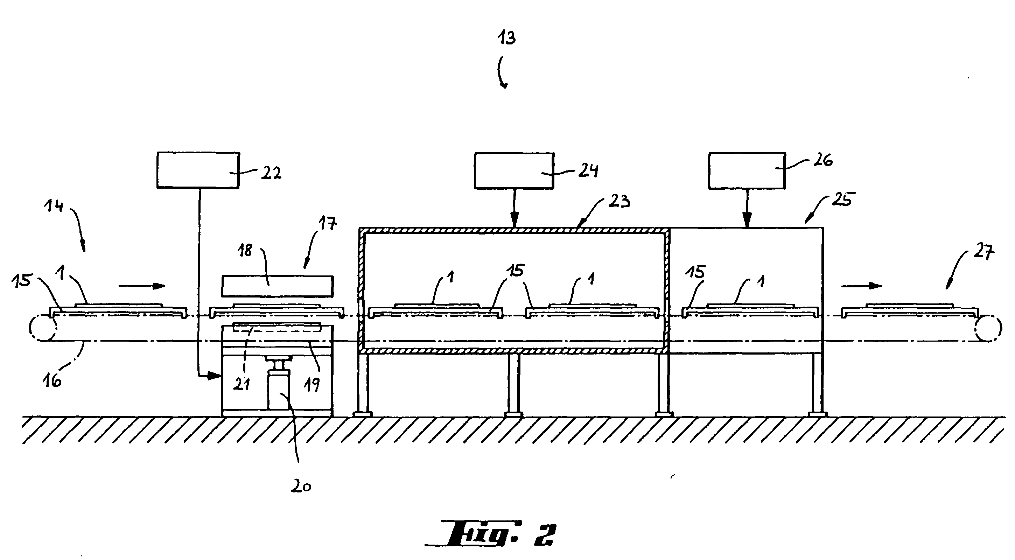

Die Erfindung wird anhand der Figuren 1 und 2 beschrieben:

Fig. 1 zeigt den Aufbau des erfindungsgemäßen fotovoltaischen Moduls 1, welcher aus dem Solarzellensystem 2 und den das Solarzellensystem umgebenden Einkapselungsmaterialien 3, 3' besteht. Das Solarzellensystem 2 wird aus einer Reihe von Siliziumzellen 8, welche in Serie mittels Kontaktierungsdrähten 9 zu Gruppen verlötet sind, gebildet. Das Einkapselungsmaterial 3' besteht aus der Kunststoff-Siegelschicht 4' und der Kunststofffolie bzw. dem Kunststofffolienverbund 6, welche(r) an der dem Solarzellensystem 2 zugewandten Oberflächenseite die aus der Dampfphase abgeschiedene Oxidschicht 7 aufweist. Dieser Schichtaufbau ist mit I gekennzeichnet. Das Einkapselungsmaterial 3 besteht beispielsweise aus der Schicht 5, welche eine Glasschicht oder ein Kunststofffolienverbund ähnlich zu 6 sein kann, und einer Kunststoff-Siegelschicht 4.

Fig.1 zeigt ferner die Varianten Ia und Ib, welche den Schichtaufbau gemäß I ersetzen können.

Gemäß Variante Ia ist die anorganische Oxidschicht 7 über eine Kleberschicht 10 mit einer zusätzlichen Kunststofffolie oder einem Kunststofffolienverbund 11 verbunden.

Gemäß Variante Ib weist die anorganische Oxidschicht 7 eine zusätzliche Primerschicht 12 auf, welche in der Folge die Verbindung zu der Siegelschicht 4' darstellt.

Fig. 2 zeigt eine Vorrichtung 13 zum Laminieren der in Figur 1 dargestellten Schichten für die Herstellung des erfindungsgemäßen fotovoltaischen Moduls 1: Sie zeigt die Beladestation 14, an der der Modulstapel 1 auf die Trägerplatte 15, welche mittels des Transportsystems 16 bewegt wird, aufgebracht werden kann, sowie den Vakuumlaminator 17 mit dem feststehenden Oberteil 15 und dem über die Hydraulikeinrichtung 20 heb- und senkbaren Unterteil 19. Temperatur, Druck und Verweilzeit werden im Vakuumlaminator 17 über das Regelungssystem 22 eingestellt. Ferner zeigt Fig. 2 den Härteofen 23, dessen Temperatur über das Regelungssystem 24 eingestellt wird, den Kühlbereich 25, dessen Temperatur über das Regelungssystem 26 einstellbar ist und den Entnahmebereich 27.

Ein Weg zur Ausführung der Erfindung

Die Erfindung wird nunmehr anhand von Ausführungsbeispielen näher erläutert:

In einem ersten Verfahrensschritt wird die Barriereschicht 6, welche die anorganische Oxidschicht 7 aufweist, gebildet. Dabei kann der Aufbau gemäß folgender Tabelle gewählt werden, wobei die Reihenfolge von außen nach innen, das heißt in Richtung Solarzellensystem angeführt wird:

TABELLE

| (Beispiele a-d): | |
| --- | --- |
| **Beispiel a** | |
| Barriereschicht (6): | |
| Verbund aus | Polyvinylfluorid (PVF) |
| | Polyethylenterephthalat (PETP) in Folienform |
| anorganische Oxidschicht (7) : $SiO_x$ oder $Al_2O_3$ | |
| <u>Siegelschicht</u> (4') | |
| **Beispiel b** | |
| Barriereschicht (6): | |
| Kunststoffolie aus Ethylentetrafluoroethylencopolymer (ETFE) | |
| anorganische Oxidschicht (7): $SiO_x$ oder $Al_2O_3$ | |
| <u>Siegelschicht</u> (4') | |
| **Beispiel c** | |
| Barriereschicht(6): | |
| Kunststoffolienverbund aus PVF und PETP | |
| anorganische Oxidschicht (7): $SiO_x$ oder $Al_2O_3$ | |
| Kleberschicht (10): beispielsweise Polyurethan | |
| Kunststoffolie oder Kunststoffolienverbund (11): Polyvinylfluorid (PVF), Polyvinylidenfluorid (PVDF), Ethylentetrafluoroethylencopolymer (ETFE), Polylethylenterephthalat (PETP) | |
| <u>Siegelschicht</u> (4') | |
| **Beispiel d** | |
| Barriereschicht (6): | |
| Kunststoffolienverbund aus PVF und PETP | |
| anorganische Oxidschicht (7): $SiO_x$ oder $Al_2O_3$ | |
| Primerschicht (12): beispielsweise Polyurethan, | |
| Ethylenvinylacetat (EVA), Polymethylmethacrylat (PMMA) | |
| <u>Siegelschicht</u> (4') | |

Aus der Tabelle ist zu ersehen, daß die Barriereschicht (6) gemäß Beispiel b) aus einer einzelnen Kunststoffolie und gemäß Beispiel a) aus einem Kunststoffolienverbund bestehen kann.

Als Siegelschichten (4') werden vorzugsweise Ethylenvinylazetat (EVA)-Folien, verwendet, welche bei Wärmebehandlung geringfügig fließen und in der Folge vernetzen, wodurch das Kriechen der Kunststoffe verhindert wird.

Auf die Kunststoffolie aus PETP (s. Beispiel a) gemäß Tabelle) wird nunmehr die anorganische Oxidschicht (7) in einer Dicke von 30 bis 200 nm durch Dampfabscheidung im Vakuum (nicht dargestellt) erzeugt. Dazu wird beispielsweise eine Vakuumbeschichtungsanlage (nicht dargestellt) verwendet. Um eine zufriedenstellende Haftung zwischen der Kunststoffolienoberfläche und dem anorganischen Oxid gewährleisten zu können, wird die Oberfläche der Kunststoffolie in einem Plasma aus Sauerstoffgas (99.995% Reinheit) vorbehandelt.

Als anorganisches Beschichtungsmaterial werden beispielsweise in stöchiometrischen Mengen Aluminiumoxid (99.9% Reinheit) oder Siliziummonoxid (99.9% Reinheit) eingesetzt und unter Anwendung von Elektronenstrahlung im Vakuum verdampft. Die bei der Verdampfung angewandte Energie betrug beispielsweise 10 keV bei einer Emissionrate bis zu 220 mA. Durch Veränderung der Verdampfungsrate oder der Geschwindigkeit der über Rollen bewegten Kunststoffolien oder Kunststoffolienverbunden kann die Dicke der $SiO_x$- oder $Al_2O_3$-Schichten im Bereich von 30 bis 200 nm eingestelllt werden.

So wird beispielsweise labortechnisch für die Herstellung einer 100 nm dicken $SiO_x$-Schicht eine Geschwindigkeit von 5 m/min gewählt, während für die Herstellung einer 40 nm dicken $Al_2O_3$-Schicht eine Geschwindigkeit von 2.5 m/min gewählt werden muß. Die Verdampfungsrate betrug dabei bis zu 70 nm/s; der beim Verdampfen angewandte Druck war etwa $5 \times 10^{-2}$Pa. Bei der industriellen Herstellung können Geschwindigkeiten eingestellt werden, die um den Faktor 100 und darüber liegen.

Die mit der anorganischen Oxidschicht versehenen Kunststoffolie, beispielsweise aus PETP, kann nun zur Herstellung des Kunststoffolienverbundes mit der weiteren Kunststoffolie, beispielsweise aus PVF (s. Beispiel a) gemäß Tabelle), kaschiert werden.

Bei den erfindungsgemäßen Varianten gemäß Beispiele a) und b) ist es nun vorgesehen, daß die anorganische Oxidschicht 7, welche vorzugsweise eine Siliziumoxidschicht ist, in direktem Kontakt mit der Siegelschicht 4' steht, wobei eine zufriedenstellende Haftvermittlung gewährleistet ist. In diesem Fall kann das atomare Verhältnis zwischen Silizium und Sauerstoff beliebig variiert werden.

Soll jedoch im erfindungsgemäßen fotovoltaischen Modul durch die anorganische Oxidschicht, vorzugsweise die Silizium-Oxidschicht zusätzlich eine UV-Filterwirkung gewährleistet sein, so ist es notwendig, das atomare Verhältnis Silizium zu Sauerstoff beim Bedampfen derart zu steuern, daß der Anteil an Sauerstoff x zwischen 1,3 und 1,7 liegt. Es kann neben den oben genannten Kriterien wie beispielsweise Auswahl im stöchiometrischen Mengenverhältnis der Ausgangsprodukte oder der Geschwindigkeit beim Bedampfen dadurch geschehen, daß zusätzlich Sauerstoff in Form eines reaktiven Gases beim Verdampfen zugeleitet wird. Es entsteht nunmehr eine im sichtbaren Lichtwellenlängenbereich hoch transparente Oxidschicht, welche dennoch UV-Strahlen absorbiert und wodurch die UV-sensiblen Siegelschichten (4') zusätzlich geschützt werden. Dies wird anhand folgender Darstellung näher erläutert:

Gemäß obiger Darstellung wird die Lichtdurchlässigkeit einer Kunststoffolie aus ETFE, welche als anorganische Oxidschicht eine $SiO_x$-Schicht in einer Dicke von 320nm aufweist, gezeigt. Daraus erkennt man, daß im UV-Bereich unterhalb 350 nm Lichtwellenlänge die mit SiOx beschichtete Kunststoffolie für Licht praktisch undurchlässig ist. Eine unbeschichtete Kunststoffolie gleicher Konstitution (nicht dargestellt) würde in diesem Bereich jedoch noch Licht absorbieren.

Ab 350 nm Lichtwellenlänge beginnt die mit $SiO_x$ beschichtete ETFE-das einfallende Licht durchzulassen. Eine signifikante Transparenz ist ab etwa 450 nm im blauvioletten Teil des Spektrums des sichtbaren Lichts zu bemerken.

Über den weiteren sichtbaren Lichtbereich beobachtet man eine hohe Transmission, die sich erst wieder im infraroten Bereich reduziert.

Um nun die Eigenschaften des erfindungsgemäßen fotovoltaischen Modules wie hohe Lichttransmission im sichtbaren Bereich und im nahen UV-Bereich bei gleichzeitiger Lichtsperrwirkung im kürzerwelligen UV-Bereich und darüberhinaus sowie eine hohe Barrierewirkung gegenüber Wasserdampf zu erhalten, stehen Freiheitsgrade zur Verfügung:

1. Variation der Dicke der anorganischen Oxidschicht.

Hierbei kann in guter Näherung nach dem Lambert-Beer'schen Gesetz über

$$\ln(I/I_o) = - 4\pi k d \lambda^{-1}$$

mit I = durchgelassene Intensität des Lichts, $I_o$ = eingestrahlte Intensität, k = Wellenlängen-abhängiger Absorptionskoeffizient, d = Schichtdicke der aufgedampften anorganischen Oxidschicht, $\lambda$ = Lichtwellenlänge, die Lichtdurchlässigkeit vorteilhafterweise beeinflußt werden.

2. Variation des Sauerstoffgehalts (x) in der anorganischen Oxidschicht, vorzugsweise $SiO_x$-Schicht.

Verschiebt man x (in obiger Darstellung 1.3) durch andere Aufdampfbedingungen zu höheren Werten, so liegt die Transmission des Materials um den Wellenlängenbereich von 400 nm höher, ohne die Schichtdicke ändern zu müssen.

Durch Sauerstoffzugabe unter gleichzeitiger Einkoppelung von elektromagnetischer Energie in Form von Mikrowellenstrahlung lassen sich Werte für x beispielsweise von etwa 1.7 einstellen. Somit gestattet eine Variation der Parameter Schichtdicke und Sauerstoffgehalt eine gleichzeitige Optimierung von Transmission im sichtbaren Lichtbereich, Sperrwirkung im ultravioletten Lichtbereich und Sperrwirkung gegenüber Wasserdampf.

Ferner wird für die Außenanwendung des erfindungsgemäßen fotovoltaischen Moduls die Witterungsbeständigkeit neben dem gezielten atomaren Verhältnis Silizium zu Sauerstoff auch dadurch gewährleistet, daß die anorganische Oxidschicht 7 beidseitig von Kunststoffolien oder Kunststoffolienverbunden umhüllt sein kann. Dies erfolgt beispielsweise gemäß Fig.1, Variante Ia dadurch, daß die Barriereschicht 6 die anorganische Oxidschicht 7 aufweist, welche wiederum über die Kleberschicht 10 mit einer weiteren Kunststoffolie oder Kunststoffolienverbund 11 in Verbindung steht. Die Kunststoffolien können gemäß Beispiel c) aus der Tabelle entsprechend ausgewählt werden und übernehmen eine weitere Schutzfunktion des Solarzellensystems gegen Witterungseinflüsse. Dabei kann die Anordung zum Solarzellensystem gemäß Fig.1/Ia auch derart gewählt werden, daß die Barriereschicht 6 an die Siegelschicht 4'anschließt, während die Kunststoffolie oder der Kunststofffolienverbund 11 die äußerste Lage im Modulstapel bildet.

Ferner ist es auch möglich, eine zufriedenstellende Witterungsbeständigkeit durch Maßgabe einer Primerschicht 12 aus Kunststoff zu bewirken, welche gemäß Fig 1/Var. Ib sowie Beispiel d) aus der Tabelle zwischen der Siegelschicht 4' und der anorganischen Oxidschicht 7 angeordnet ist.

Sämtliche Varianten können nunmehr in das Laminierverfahren mithilfe der Vorrichtung 13 gemäß Fig.2 eingesetzt werden, um den fotovoltaischen Modul 1 auszubilden. Es wird beispielhaft, jedoch nicht einschränkend, eine Variante herausgegriffen.

Dabei wird die mit der anorganischen Schicht 7 versehene Barriereschicht 6 mit der Kunststoff-Siegelschicht 4', dem Solarzellensystem 2, einer weiteren Kunststoff-Siegelschicht 4 sowie der Glasschicht 5, wie in Fig. 1 dargestellt, verschlichtet.

Anstelle der Glasschicht 5 kann ebenso ein PET/PVF-Kunststoffolienverbund eingesetzt werden.

Ferner soll die Schicht 5, insbesondere bei der Außenanwendung witterungsbeständig und dekorativ sein, sodaß beispielsweise dekorative, mit einer Acrylatschicht versehene Schichtpreßstoffplatten mit der Bezeichnung MAX[(R)] EXTERIOR geeignet sind.

Dieser Modulstapel wird nun zum Laminieren in die Vorrichtung 13 gemäß Figur 2 eingebracht. Dabei wird der Modulstapel 1 an der Beladestation 14 auf die Trägerplatte 15 gelegt, welche auf Raumtemperatur jedoch maximal auf einer Temperatur von 80°C gehalten wird.

An seiner Ober- und Unterseite ist der Modulstapel mit Trennfolien (nicht dargestellt) versehen, um eine Haftung an der Trägerplatte 15 sowie an den übrigen Anlagenteilen zu vermeiden.

Nach der Aufgabe des Modulstapels 1 auf die Trägerplatte 15 wird diese über das Transportsystem 16, beispielsweise einen Kettenförderer, in den Vakuumlaminator 17 befördert. Die Temperatur der Heizplatte 21 wird darin über ein externes Regelungssystem 22 auf einer Temperatur entsprechend der Erweichungstemperatur der in der Siegelschicht eingesetzten Kunststoffmaterialien gehalten. Durch die Hydraulikvorrichtung 20 wird die Heizplatte 21 gegen die Trägerplatte 15 gedrückt, sodaß - bedingt durch den Wärmestrom innerhalb der Trägerplatte - die Kunststoff-Siegelschichten 4, 4' im Modulstapel auf ihre Erweichungstemperatur gebracht werden.

Nach dem Schließen des Laminators 17 wird über die externe Regelungseinrichtung 22 ein Vakuum angelegt. Durch die Evakuierung werden Luft und sonstige volatile Bestandteile aus dem Modulstapel entfernt, sodaß ein blasenfreies Laminat gewährleistet ist. Anschließend wird belüftet, wodurch die flexible Membran (nicht dargestellt) an den Modulstapel gepreßt wird. Nach einer definierten Verweilzeit des Modulstapels 1 im Vakuumlaminator 17 wird dieser belüftet und der Modulstapel ohne weiteren Preßdruck in den Härteofen 23 transportiert. Darin wird dieser bedingt durch das Regelungssystem 24 auf einer definierten Temperatur gehalten, sodaß die Siegelschichten im Modulstapel während einer definierten Verweilzeit aushärten und ein Laminat gebildet wird, welches anschließend im Kühlbereich 25 auf Raumtemperatur gekühlt wird. Das ausgehärtete Laminat wird im Entnahmebereich 27 von der Trägerplatte abgenommen und die rückgekühlte Trägerplatte kann zur Beladestation 14 rückgeführt werden.

Das erfindungsgemäße fotovoltaische Modul 1 kann als Solarzellensystem 2 anstelle der kristallinen Siliziumzellen auch sogenannte Dünnschicht-Solarzellen aufweisen. In diesem Fall kann das Solarzellensystem mit den Einkapselungsmaterialien 3,3' beispielsweise mittels Verpressen oder Kalandrieren verbunden werden. Diese Dünnschichtsolarzellen sind zwar nicht bruchempfindlich, jedoch wasserempfindlich, sodaß sich der erfindungsgemäße Lösungsvorschlag besonders anbietet.

Der fotovoltaische Modulstapel kann beispielsweise folgenden Aufbau haben:

Beispiel e)

Schicht (5): Glas
Solarzellensystem (2): Dünnschichtsolarzelle aus amorphem Silizium
Siegelschicht (4'): EVA
Barriereschicht (6): aus ETFE-Kunststoffolie mit anorganischer Oxidschicht (7) aus SiOx

Beispiel f)

Schicht (5): Glas
Solarzellensystem (2): Dünnschichtsolarzelle aus Cadmiumtellurid
Siegelschicht (4'): EVA
Barriereschicht (6): Kunststoffolienverbund aus PVF/PET und anorganischer Oxidschicht (7) aus $SiO_x$

In den Beispielen gemäß e) und f) wird das Dünnschichtsolarzellensystem durch die Barriereschicht 6 gegen Wasserdampf geschützt. Da jedoch diese nicht bruchempfindlich ist, kann die zusätzliche Siegelschicht 4 wegfallen.

Gewerbliche Anwendbarkeit

Die durch das erfindungsgemäße Verfahren hergestellten fotovoltaischen Module dienen zur elektrischen Energieerzeugung aus Sonnenlicht. Ihre Anwendungsmöglichkeiten sind vielfältig und reichen von Kleinenergieanlagen für Notrufsäulen oder Wohnmobile über Gebäude integrierte Dach- und Fassadenanlagen bis hin zu Großanlagen und Solarkraftwerken.

Bei den Anwendungen im Außenbereich hat es sich gezeigt, daß die Barrierewirkung gegenüber Wasserdampf durch die aus der Dampfphase abgeschiedene Oxidschicht wesentlich verbessert wird. Dies geht aus folgender Tabelle hervor:

Dabei wurden unbeschichtete Folien (linker Balken auf der Abszisse) mit $SiO_x$-beschichteten Folien (rechter Balken auf der Abszisse) hinsichtlich ihrer Wasserdampfdurchlässigkeit in $g/m^2d$ verglichen.

Bei diesem Vergleich ist zu ersehen, daß im Falle von PET der Type RN 12 die Wasserdampfdurchlässigkeit auf etwa ein Zehntel des Wertes des unbeschichteten Materials reduziert werden konnte, im Falle der Type RN 75 auf 1/25. Für ETPE mit einer Materialstärke von 20 μm wird die Wasserdampfdurchlässigkeit sogar um etwa den Faktor 100 herabgesetzt.

**Patentansprüche**

1. Fotovoltaischer Modul 1 in Form eines Laminates, welches als Kernschicht ein Solarzellensystem 2 sowie beidseitig an dieses angebrachte Einkapselungsmaterialien 3,3' aufweist, dadurch gekennzeichnet, daß zumindestens eine Einkapselungsmaterialschicht 3' aus einer Siegelschicht 4' und einer Barriereschicht 6 besteht und daß die Barriereschicht 6 aus einer Kunststoffolie oder einem Kunststoff-Folienverbund ausgebildet ist, welche(r) eine aus der Dampfphase abgeschiedene, anorganische Oxidschicht 7 aufweist.

2. Fotovoltaischer Modul nach Anspruch 1, dadurch gekennzeichnet, daß die anorganische Oxidschicht 7 aus den Elementen Aluminium oder Silicium besteht und in einer Dicke von 30 bis 200 nm vorliegt.

3. Fotovoltaischer Modul nach Anspruch 1 oder 2, dadurch gekennzeichnet, daß die anorganische Oxidschicht 7 im sichtbaren Lichtwellenbereich und im nahen UV-Wellenlängenbereich für Lichtstrahlen durchlässig ist, während sie im UV-Wellenlängenbereich bei kürzeren Wellenlängen diese absorbiert.

4. Fotovoltaischer Modul nach einem der Ansprüche 1 bis 3, dadurch gekennzeichnet, daß die Siegelschicht 4' zwischen dem Solarzellensystem 2 und der Barriereschicht 6 angeordnet ist und vorzugsweise aus Ethylenvinylacetat (EVA) besteht.

5. Fotovoltaischer Modul nach einem der Ansprüche 1 bis 4, dadurch gekennzeichnet, daß die Kunststoffolie, auf welcher die anorganische Oxidschicht abgeschieden ist, aus Polyethylenterephthalat (PET) oder Ethylentetrafluoroethylencopolymer (ETFE) besteht.

6. Fotovoltaischer Modul nach einem der Ansprüche 1 bis 5, dadurch gekennzeichnet, daß die anorganische Oxidschicht 7 dem Solarzellensystem 2 zugewandt ist und in direktem Kontakt mit der angrenzenden Siegelschicht 4' steht.

7. Fotovoltaischer Modul nach einem der Ansprüche 1 bis 5, dadurch gekennzeichnet, daß die anorganische Oxidschicht 7 dem Solarzellensystem 2 zugewandt ist und über eine Primerschicht 12 mit der angrenzenden Siegelschicht 4' in Kontakt steht.

8. Fotovoltaischer Modul nach einem der Ansprüche 1 - 5, dadurch gekennzeichnet, daß die anorganische Oxidschicht 7 beidseitig von Kunststoffolien oder -verbunden 6,11 umgeben ist, wobei zumindestens eine Kunststoffolie oder ein Kunststoffolienverbund die Funktion der Barriereschicht 6 übernimmt.

9. Fotovoltaischer Modul nach Anspruch 8, dadurch gekennzeichnet, daß die anorganische Oxidschicht 7 über zumindestens eine Kleberschicht 10 mit dem Kunststoffolien oder -verbunden 11 in Kontakt steht.

10. Fotovoltaischer Modul nach einem der Ansprüche 1 - 9, dadurch gekennzeichnet, daß die anorganische Oxidschicht 7 aus $SiO_x$ besteht, wobei das atomare Verhältnis von Silizium zu Sauerstoff x in einem Bereich von 1,3 - 1,7 liegt.

11. Verfahren zur Herstellung eines fotovoltaischen Moduls gemäß einem der Ansprüche 1 bis 10, dadurch gekennzeichnet, daß

a) eine Kunststoffolie oder ein Kunststoffolienverbund 6 mit einer aus der Dampfphase abgeschiedenen, anorganischen Oxidschicht 7 versehen wird, daß

b) ein Modulstapel 1 , welcher aus dem Solarzellensystem 2 sowie den Einkapselungsmaterialien 3,3' derart verschlichtet wird, daß die Siegelschichten 4,4' das Solarzellensystem 2 beidseitig umhüllen, daß

c) dieser Modulstapel in eine Beladestation 14 einer Vorrichtung 13 eingebracht wird, in welcher er auf eine Temperatur unterhalb der Erweichungstemperatur der Siegelschichten 4,4'gehalten wird, daß

d) der Modulstapel in einen Vakuumlaminator 17 dieser Vorrichtung 13 transportiert wird, welcher evakuiert wird, und in welchem der Modulstapel auf die Erweichungstemperatur der Siegelschichten 4,4' erwärmt wird und daß

e) nach dem Belüften des Vakuumlaminators 17 ohne Rückkühlung der aus dem Modulstapel gebildete Verbund in den Härteofen 23 transportiert wird, in welchem die Siegelschichten 4,4' ausgehärtet werden, sodaß ein Laminat 2 in Form eines fotovoltaischen Moduls gebildet wird, welches nach Rückkühlung dem kontinuierlichen Verfahrensablauf entnommen werden kann.

Fig. 1

Fig. 2

**Europäisches Patentamt**

# EUROPÄISCHER RECHERCHENBERICHT

**Nummer der Anmeldung**

EP 98 11 2319

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | WO 97 36334 A (PROBST VOLKER ;CALWER HERMANN (DE); SIEMENS AG (DE); STETTER WALTE) 2. Oktober 1997 | 1-3,6 | H01L31/048 B32B31/00 |
| Y | * Seite 3, Zeile 24 – Seite 5, Zeile 17; Abbildungen 1-4 * <br> * Seite 13, Zeile 15-25; Ansprüche 1-3,7-9,11 * | 1,4,5,7,8,11 | |
| D,Y | WO 94 29106 A (ISOVOLTA ;FALK JOHANN (AT); PLESSING ALBERT K (AT)) 22. Dezember 1994 <br> * Seite 4, Zeile 21 – Seite 8, Zeile 13; Ansprüche 1,2,6,7,9; Abbildungen 1,2 * | 1,4,5,7,8,11 | |
| X | DE 196 11 410 C (SIEMENS AG ;SIEMENS SOLAR GMBH (DE)) 7. August 1997 | 1,2,4,6 | |
| Y | * Spalte 3, Zeile 27 – Spalte 4, Zeile 7; Ansprüche 1-3; Abbildungen 1-3 * | 1,5,7,8,11 | |
| A | PATENT ABSTRACTS OF JAPAN vol. 095, no. 006, 31. Juli 1995 & JP 07 074378 A (MITSUI TOATSU CHEM INC), 17. März 1995 <br> * Zusammenfassung * | 1,2,10 | |
| A | PATENT ABSTRACTS OF JAPAN vol. 098, no. 005, 30. April 1998 & JP 10 025357 A (DAINIPPON PRINTING CO LTD), 27. Januar 1998 <br> * Zusammenfassung * | 1-3 | |
| A | WO 92 06847 A (UNITED SOLAR SYSTEMS CORP) 30. April 1992 | | |
| A | US 4 433 200 A (JESTER THERESA L  ET AL) 21. Februar 1984 | | |

**RECHERCHIERTE SACHGEBIETE (Int.Cl.6)**

H01L
B32B

Der vorliegende Recherchenbericht wurde für alle Patentansprüche erstellt

| Recherchenort | Abschlußdatum der Recherche | Prüfer |
|---|---|---|
| DEN HAAG | 20. November 1998 | Visentin, A |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

......................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 98 11 2319

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-11-1998

| Im Recherchenbericht angeführtes Patentdokument | Datum der Veröffentlichung | Mitglied(er) der Patentfamilie | Datum der Veröffentlichung |
|---|---|---|---|
| WO 9736334 A | 02-10-1997 | DE 19611410 C<br>DE 19707280 A<br>WO 9838683 A | 07-08-1997<br>27-08-1998<br>03-09-1998 |
| WO 9429106 A | 22-12-1994 | AU 676330 B<br>AU 6836994 A<br>CA 2141946 A<br>EP 0655976 A<br>JP 8500214 T<br>US 5593532 A | 06-03-1997<br>03-01-1995<br>22-12-1994<br>07-06-1995<br>09-01-1996<br>14-01-1997 |
| DE 19611410 C | 07-08-1997 | WO 9736334 A | 02-10-1997 |
| WO 9206847 A | 30-04-1992 | AT 155739 T<br>AU 8842791 A<br>DE 69126985 D<br>EP 0553211 A<br>JP 6510631 T<br>US 5238519 A | 15-08-1997<br>20-05-1992<br>04-09-1997<br>04-08-1993<br>24-11-1994<br>24-08-1993 |
| US 4433200 A | 21-02-1984 | KEINE | |

EPO FORM P0461

Für nähere Einzelheiten zu diesem Anhang : siehe Amtsblatt des Europäischen Patentamts, Nr.12/82